Europäisches Patentamt

European Patent Office

Office européen des brevets

(11) Publication number: **0 099 926**
**B1**

(12) **EUROPEAN PATENT SPECIFICATION**

(45) Date of publication of patent specification: **21.01.87**

(21) Application number: **83901003.0**

(22) Date of filing: **01.02.83**

(86) International application number:
**PCT/US83/00143**

(87) International publication number:
**WO 83/02852 18.08.83 Gazette 83/19**

(51) Int. Cl.⁴: **H 01 L 29/747, H 01 L 29/78**

(54) FIELD-EFFECT CONTROLLED BI-DIRECTIONAL LATERAL THYRISTOR.

(30) Priority: **09.02.82 US 347094**

(43) Date of publication of application:
**08.02.84 Bulletin 84/06**

(45) Publication of the grant of the patent:
**21.01.87 Bulletin 87/04**

(84) Designated Contracting States:
**DE FR**

(56) References cited:
**EP-A-0 047 392**
**FR-A-2 443 172**
**US-A-3 816 763**
**US-A-3 881 118**
**US-A-3 938 176**
**US-A-3 940 634**
**US-A-3 959 668**
**US-A-4 063 115**
**US-A-4 137 428**
**US-A-4 199 774**
**US-A-4 227 098**
**US-A-4 232 234**
**US-A-4 239 985**

(73) Proprietor: **Western Electric Company,**
**Incorporated**
**222 Broadway**
**New York, NY 10038 (US)**

(72) Inventor: **CHANG, Gee-Kung**
**116 Gallinson Drive**
**New Providence, NJ 07974 (US)**
Inventor: **HARTMAN, Adrian Ralph**
**5 Brook Hollow Lane**
**Murray Hill, NJ 07974 (US)**
Inventor: **WESTON, Harry Thomas**
**51 Holly Glen Lane North**
**Berkeley Heights, NJ 07922 (US)**

(74) Representative: **Buckley, Christopher Simon**
**Thirsk et al**
**Western Electric Company Limited 5**
**Mornington Road**
**Woodford Green Essex IG8 OTU (GB)**

(56) References cited:
**US-A-4 244 000**
**US-A-4 264 786**
**US-A-4 295 058**
**US-A-4 302 687**

0 099 926

(56) References cited:

US-A-4 303 831
US-A-4 321 644
US-A-4 331 884
US-A-4 365 170

International Electron Device Meeting
Technical Digest, Issued 08 December 1980, J.
Tihanyi, "Functional Integration of Power Mos
and Bipolar Devices," pp. 75-78, 80CH 1616-2.

International Electron Device Meeting
Technical Digest, Issued 08 December 1980, L.
Leipold et al. "A Fet-Controlled Thyristor in
Sipmos Technology," pp. 79-82, 80 Ch 1616-2.

1978 IEEE International Solid-State Circuit
Conference, San Francisco, Issued 17 February
1978, B. Scharf et al., "A Mos-Controlled Triac
Device," pp. 222-223.

IEEE Transactions on Electron Devices, Vol.
ED-27, no. 2, Issued February 1980, J. Plummer
et al., "Insulated-Gate Planar Thyristors: I and
II" pp. 380-394.

## Description

This invention relates to semiconductor switches.

In telecommunications there is a growing need for an inexpensive switch that is able to withstand high voltages of either polarity in the OFF state. It would be particularly advantageous if the switching could be easily controlled by the photovoltaic voltage of a photosensitive element or by an electrical logic signal.

Important in achieving a switch of this kind would be a solid-state relay having a low resistance in the ON state to currents flowing in either direction, a high resistance in the OFF state in either direction even to high voltages, and the capability of being switched between these states with a relatively low control voltage.

A device that meets some of these characteristics has been described in a United States Patent No. 4,199,774 which was issued on April 22, 1980, to J. D. Plummer. This device involves the merger, in a semiconductive body essentially on a single top surface, of a pair of MOS transistors, of a form known as DMOS, and an NPNPN triac. This device is further described in a pair of papers in the *IEEE Transactions on Electron Devices*, Vol. ED27, No. 2, February 1980, pp. 380—394, entitled "Insulated-Gate Planar Thyristors."

A DMOS transistor is so called because it was originally made by a double-diffusion process. A distinctive characteristic of such a transistor is that the source region is included within a closely surrounding shielding layer of the opposite type, a portion of which lies adjacent the surface and underlies the gate electrode, whereby it can be inverted-to serve as the channel of the transistor. The source and shielding layer in turn are enclosed in a bulk portion which is of the conductivity type of the source and serves as the drain.

In this prior art device, the five layers of the triac are formed in turn by the source and shielding layer of the first transistor, the common drain of the two transistors, and the shielding layer and source of the second transistor. In the basic structure, three terminals are included and formed in turn by a connection common to the gates of the two transistors, a connection common to the source and shielding layer of the first transistor and a connection common to the source and shielding layer of the second transistor. The two last-mentioned connections serve as the main terminals between which the resistance is controlled by voltages applied to the first-mentioned connection.

Various other embodiments are described in the patent and papers including some in which a localized low resistivity region is included at the top surface of the common drain region intermediate between the two shielding regions, and an electrode connection is provided to this region. In such embodiments, the localized region serves as a channel stop to reduce the tendency to form a surface inversion layer extending between the two shielding layers.

We have found that this prior art device has limitations which reduce its attractiveness.

In particular, it is characteristic of this device that for reliability it is important that the gates of the two transistors be rugged enough to withstand, without damage, essentially the full voltage applied between the two main terminals. For applications in which this voltage is apt to be high, for example hundreds of volts, this imposes stringent requirements on the gate, particularly the gate insulation.

Additionally, with this structure, the current flow through the device is largely only the lateral flow adjacent the top surface of the semiconductive body in which it is formed. Because of the limited volume available for current flow, the ON resistance tends to be higher than would be the case if more of the volume of the body could be used for current flow through the device when it is ON.

According to one aspect of this invention a switch includes a semiconductor body having a bulk portion of relatively high resistivity of one conductivity type, and within the bulk portion first and second spaced apart surface source regions of the one conductivity type, and first and second spaced shield regions of the opposite conductivity type enclosing the first and second source regions, respectively, a first electrode making a direct electrical connection to both the first source and first shield regions, a second electrode making a direct electrical connection to both the second source and second shield regions, a third electrode overlying and insulated from a surface portion of the first shield region relatively remote from the second shield region for serving as a gate electrode for selectively inverting that portion of the shield region and forming a channel therein, a fourth electrode overlying and insulated from a surface portion of the second shield region relatively remote from the first shield region for serving as a gate electrode for selectively inverting that portion of the second shield region and forming a channel therein, and a fifth electrode overlying and insulated from a surface portion of the second shield region relatively adjacent the first shield region and making a direct electrical connection to the second electrode, the first source region, the portion of the first shield region relatively remote from the second shield region, the bulk portion and the third electrode cooperating to form a first MOS transistor, the second source region, the portion of the second shield region relatively remote from the first shield region, the bulk portion and the fourth electrode cooperating to form a second MOS transistor, and the first shield region, the bulk portion, the second shield region, and the second source region cooperating to form a thyristor, and there is provided a pair of oppositely poled diodes having a common terminal connected to a source of control signals and two other terminals connected to the third and fourth electrodes, respectively.

According to another aspect of this invention a switch includes a semiconductor body having a bulk portion of relatively high resistivity of one conductivity type, and within the bulk portion first and second spaced apart surface source regions of the one conductivity type, and first and second spaced shield regions of the opposite conductivity type enclosing the first and second source regions, respectively, a first electrode making a direct electrical connection to the first source and first shield regions, a second electrode making a direct electrical connection to the second source and second shield regions, a third electrode overlying only a limited surface portion of the first shield region relatively remote from the second shield region and insulated therefrom for serving as a gate electrode for selectively inverting that portion of the shielding region and forming a channel therein, and a fourth electrode overlying essentially all of the surface portion of the second shielding region for selectively inverting that surface portion of the shielding region and forming a channel therein, the first source region, the portion of the first shield region underlying the third electrode, the bulk portion and the third electrode cooperating to form a first MOS transistor, the second source region, the second shield region, the bulk portion and the fourth electrode cooperating to form a second MOS transistor, and the portion of the first source region relatively close to the second source region, the bulk portion, the second shield region, and the second source region cooperating to form a thyristor, and there is provided a pair of oppositely poled diodes having a common terminal connected to a source of control signals and two other terminals connected to the third and fourth electrodes, respectively.

According to a further aspect of this invention a switch includes a semiconductor body having a bulk portion of relatively high resistivity of one conductivity type, and within the bulk first and second sets of MOS transistors and at least one set of thyristors, each transistor including a surface source region of the one conductivity type, a drain region of the one conductivity type and intermediate the source and drain regions a shield region of the opposite conductivity type surrounding the source region and including a surface portion adapted to be inverted for forming a channel between the source and drain regions, the drain regions of all the transistors being merged in the bulk portion, a first set of source/shield electrode means for making direct electrical connection both to each source and shield regions of the first set of MOS transistors, a second set of source/shield electrode means for making direct electrical connection both to each source and shield regions of the second set of MOS transistors, a first set of gate electrode means overlying and insulated from the surface portions to be inverted for forming channels of the first set of MOS transistors, a second separate set of gate electrode means overlying and insulated from the surface portions to be inverted for forming channels of the second set of MOS transistors, each thyristor comprising a first cathode surface region of the one conductivity type, a second enclosing region of the opposite conductivity type surrounding the cathode region, a third anode-gate region of the one conductivity type enclosing the second region, and a fourth anode region of the opposite conductivity type enclosed within the third region, the second region including a first surface portion relatively remote from the anode region adapted to be inverted for forming a channel between the first and third regions and a second surface portion relatively close to the anode region adapted to remain uninverted, the anode-gate regions of all the thyristors being merged with one another and with the drain regions of all the transistors in the bulk portion of the body, cathode electrode means making direct electrical connection to the cathode and second regions of each thyristor and the first set of source/shield electrode means, gate electrode means overlying and dielectrically spaced from each first surface portion of the second region for inverting that surface portion and forming the channel between the cathode and anode-gate region, the gate electrode means being directly connected to the first set of gate electrode means, and anode electrode means making direct connection to the fourth anode regions of all the thyristors and the second set of source/shield electrode means, and further including of pair of oppositely poled diodes having a common terminal connected to a source of control signals and two other terminals connected to the first and second sets of gate electrode means, respectively.

The invention will now be described with reference to the accompanying drawings, in which:—

FIGS. 1 and 6 illustrate different forms of switches embodying the invention utilizing solid-state relays and auxiliary circuitry in which the relay is shown in equivalent discrete circuit element form;

FIG. 2 shows in cross section a solid-state relay; and

FIGS. 3, 4 and 5 show in cross section illustrative forms of a solid-state relay for use in Figs. 1 and 6.

The drawings are not to scale.

A switch in accordance with our invention utilizes a novel solid-state relay portion cooperating with a novel auxiliary circuit portion.

In particular, although in some embodiments the solid-state relay portion similarly comprises a pair of DMOS transistors merged with a double-gated five-layer triac (we prefer to treat the triac by its equivalent arrangement of a parallel pair of oppositely poled four-layer thyristors), for the preferred applications our relay is provided with five terminals including a terminal adapted to provide a connection essentially to the entire volume of the common drain bulk portion of the body and individual terminals to the gate and source/shielding layer electrodes of each transistor, which are kept electrically separate, and the auxiliary circuit portion ordinarily utilizes all five terminals. This change in terminals allows us to prevent the full voltage applied between the main electrodes from appearing across the insulating dielectric beneath the gate electrodes.

Additionally, by including a highly conductive layer extending laterally on the opposite surface of the body and providing a connection to this layer, a low resistance connection is provided to the common drain bulk of the body, and conduction through the body in the ON state is substantially enhanced whereby the ON resistance may be lowered conveniently. In our embodiment because of the difference in role, the highly conductive layer to which is made the common drain connection is advantageously not included in the surface region intermediate between the shielding layers, as is suggested for some embodiments in the Plummer patent, but rather at an edge of the body removed from the active portion of the top surface.

By the emphasis on added vertical conduction, various modifications are made feasible in the basic prior art device. In particular, the paralleling of transistors to increase the current handling capacity of the relay is made practical.

These changes in the relay supplement appropriate changes in the auxiliary circuitry to ensure that voltages applied between the main terminals are not transmitted to the gates of the transistors. The combination results in a switch able to withstand high voltages without imposing these high voltage requirements on the more sensitive elements of the solid-state relay.

These make feasible a switch able to switch high voltages, e.g., hundreds of volts, under the control of optical pulses or electrical pulses.

Moreover, in some instances it is unnecessary to provide bilateral protection since only excessive potentials of a single polarity can be expected to reach the switch. By viewing the protection portion of the relay as a pair of oppositely poled thyristors rather than a single triac, it becomes easier to take advantage of this lessened need for over-voltage and current surge protection to make for a better switch.

In an illustrative embodiment, the solid-state relay portion comprises a dielectrically-isolated relatively large monocrystalline silicon tub in a polycrystalline silicon chip which includes on the top surface a pair of MOS transistors of the DMOS type which are merged with a pair of PNPN thyristors. The opposite surface of the tub is provided with a layer or skin of low resistivity material while its bulk is of high resistivity material. The bulk of the tub serves as a common drain for the two transistors and as the gate of each of the two thyristors. The two main current-handling terminals of the relay comprise connections common to the source and shielding layers of the two transistors. The gate electrodes of the two transistors are maintained electrically separate, and separate terminal connections are provided to the individual gate electrodes. A fifth terminal is provided by a low resistance connection to the bulk at an edge region of the top surface remote from the active surface portion between the two transistors.

The switch further includes auxiliary circuitry comprising a control portion to which are supplied the control signals used to change the OFF—ON state of the relay appropriately and an energizing portion by which the voltage to be switched is applied to the relay portion. The energizing circuitry is such that the voltage difference between each gate electrode and its associated source is only a small fraction of the voltage difference between the main terminals. Advantageously, this auxiliary circuitry is largely integrated in a common chip with the tub structure described. In some instances this auxiliary circuitry includes a source of control voltages, advantageously a photodiode array to be illuminated by a separate LED to provide a photovoltaic voltage which is applied between the source and gate of each transistor. Additionally, there are included blocking diodes and resistors to distribute appropriately the control voltages to the separate gate electrodes and to insure appropriate voltage on the various terminals of the relay.

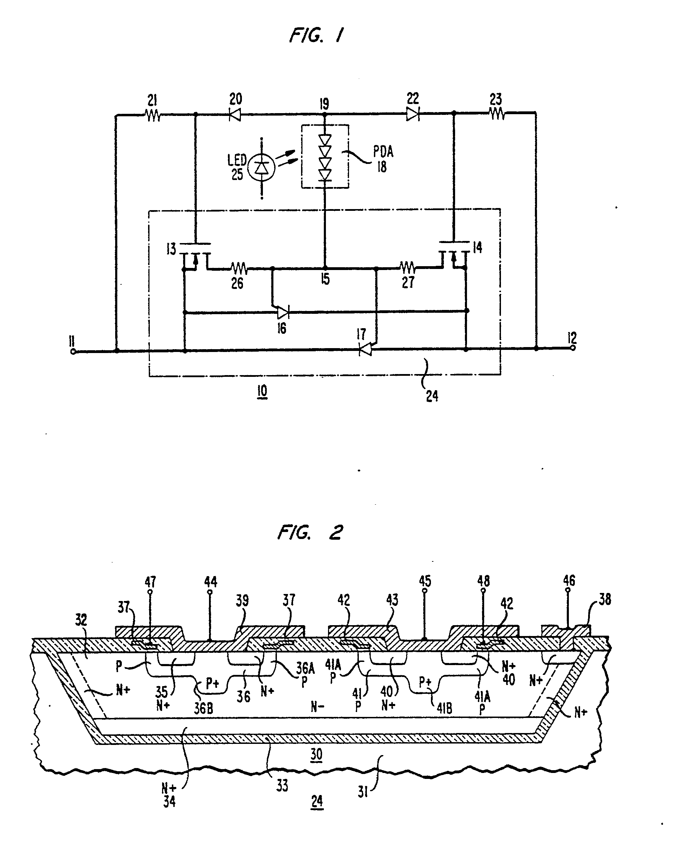

With reference now to the switch 10 shown in circuit schematic form in FIG. 1, it includes main current-handling or external terminals 11 and 12, the resistance between which is to be varied from a high value, typically at least a megohm to a low value, typically less than a hundred ohms, in accordance with control signals.

Enhancement type transistors 13, 14, advantageously of DMOS N-type, are connected to have their channels in series between terminals 11 and 12. The "source" of transistor 13 is connected to terminal 11, the "source" of transistor 14 is connected to terminal 12 and their "drains" are connected together to form node 15. It should be noted that as used herein and as has become conventional in the DMOS transistor art, the term "drain" is used to describe the region which forms the bulk of the transistor as opposed to the localized region (the "source") which is enclosed within the shielding layer and shares a common electrode with the shielding layer. In actual operation, depending on the polarity of the applied voltage, this bulk region may serve either as the functional source supplying the majority carriers flowing through the channel or as the functional drain collecting such majority carriers. PNPN thyristors 16 and 17 are also connected, in antiparallel relation, between terminals 11 and 12 and each has its anode-gate connected to the node 15. The combination of the two thyristors could also be represented by a single NPNPN double-gated triac, as is done in the earlier-mentioned patent.

A photosensitive element 18, which typically is a photodiode array, is connected between node 15 and node 19. Blocking diode 20 and resistor 21 are serially connected between node 19 and terminal 11. Similar blocking diode 22 and resistor 23 are serially connected between node 19 and terminal 12. The resistors 21 and 23 typically need to have large resistance values and advantageously can be pinch resistors having a low saturation current. The gates of transistors 13 and 14 are connected to the nodes between diode 20 and resistor 21, and diode 22 and resistor 23, respectively.

Typically, in the merged device, there will be resistance between the gates of the thyristors and the drains of the DMOS transistors and this has been indicated by the resistors 26 and 27. The size of such parasitic resistors affects the current at which the thyristors latch to a conducting or ON condition.

In operation, a voltage is applied between the external terminals 11 and 12, but in the absence of radiation incident on photosensitive element 18, insignificant current flows because each of the paths between terminals 11 and 12 includes high resistance, either in the form of one of the blocking diodes 20, 22, the OFF transistors 13, 14 or the OFF thyristors 16, 17. Each of the transistors is off because the gate-source voltage on each transistor is below the threshold for formation of the conductive channel in the transistor. This gate-source voltage is below threshold because the resistors 21 and 23 hold the gate potentials very close to those of terminals 11 and 12, respectively. Each of the thyristors is off because the absence of significant current flow through node 15 permits essentially no current to flow to their gates. Moreover, because diodes 20 and 22 are oppositely poled, one of the two will be oppositely poled or in a high resistance state for either polarity of the voltage between terminals 11 and 12.

Photosensitive element 18 is optically coupled to a suitable light source 25, typically a light-emitting diode, to which are applied the switching signals. When sufficient radiation is made incident on the photosensitive element 18, it serves as a photocell to provide current to charge the gate capacitances and as a supply of gate-source biasing voltage for each of the transistors. To this end, the polarities of each of diodes 20 and 22 relative to the photovoltaic voltage developed are such as to pass readily the photovoltaic currents which flow, and these charge the gate-source capacitances of each transistor appropriately for creating the inversion layers which turn the transistors on. In an illustrative embodiment, the photodiode array 18 is designed to generate a voltage, typically of about 10 volts, for turning on transistors 13 and 14. With transistors 13 and 14 each turned on to a low resistance, voltages maintained between terminals 11 and 12 will cause current flow therebetween whose magnitude is related essentially linearly to that of the voltage maintained, independently of the polarity of the applied voltage.

The OFF state can be reestablished by extinguishing the light illuminating the photosensitive element, thereby rendering it an open circuit. In this case the charge stored on the gate capacitors of the transistors is discharged via the resistors 21, 23 to the terminals 11, 12, the gate potentials approach the terminal potentials, and the transistors stop conducting when the inversion layer disappears.

Thyristors 16 and 17 are so designed that, as long as normal currents are flowing, the voltage at node 15 is insufficient to trigger either of them to its ON state, so that these are dormant. However, these thyristors are further designed to be turned on if the current flow past node 15 rises beyond a design limit. Such abnormal flow raises the voltage at node 15 sufficiently that the resultant voltage on the gate of the appropriate one of thyristors 16, 17, depending on the polarity of the voltage between terminals 11, 12, is sufficient to turn it on. In this ON state it serves to divert current from the transistors and to minimize the likelihood of damage from excess current flow therethrough. The thyristors 16, 17 are further designed so that with the cessation of abnormal current flow past node 15 and its return to normal levels, the current available at the anode of the ON thyristor is insufficient to maintain it in this state and it reverts to its OFF state.

It is an advantage of the circuit depicted that the elements within the broken line 24, comprising the two transistors and the two thyristors, can be provided by a single component which merges these various elements. It will be convenient to describe this component as a "solid-state relay" and to describe this portion of the switch as the solid-state relay portion. The remainder of the switch is considered to be the auxiliary circuit portion and it includes a control portion including primarily the photodiode array 18 and the energizing portion including the diodes 20, 22 and resistors 21, 23, and associated conductors providing the five leads for connection to the five electrodes of the solid-state relay portion.

The solid-state relay portion is particularly well adapted for merger into a single structure because of the common connection of the drains of the two transistors and the gates of the two thyristors. This permits a single zone or region of uniform conductivity type of a semiconductive body to serve each of these roles in a merged structure. Before describing various forms of solid-state relay for use in performing the invention, the solid-state relay shown in Fig. 2 will be described.

FIG. 2 shows a solid-state relay portion 24 formed in a monocrystalline silicon tub in a chip 30, the main portion 31 of which is polycrystalline silicon and which would normally house a plurality of such tubs each dielectrically isolated from one another in the manner known to workers in the art. In particular, the figure shows only one silicon tub, the bulk 32 of which is relatively high resistivity N-type (shown as N−), typically with a doping of less than $10^{15}$ per cubic centimeter, and which is dielectrically isolated from the polycrystalline bulk 31 by the silicon oxide layer 33. A relatively lower resistivity N-type skin layer 34 (shown as N+) is included in the bottom surface of the tub at its interface with the oxide layer 33. Often it will be advantageous to extend the layer 34 to include the sidewalls of the tub as shown by the broken line. The average doping concentrations in the regions 32 and 34 differ by at least a factor of ten, and advantageously more.

At its surface, the tub includes the left and right enhancement-mode N-type vertical DMOS transistors. The left transistor comprises the annular N-type source 35 which is surrounded by a common P-type shield region 36 whose outer lightly doped surface portion 36A serves as a channel. The surface portion 36A underlies the annular oxide-insulated gate electrode 37 which, when appropriately biased, acts to invert the surface portions for creation of the channel in the manner characteristic of MOS transistor operation. The N-type bulk 32, together with the skin layer 34 serves as the drain of the transistor. To this end, electrode 38 makes an ohmic connection to the bulk at one edge. Since, in this structure, electrode 38 needs conduct only small currents, essentially only the photocurrents generated by the photodiode array, it can tolerate resistance in its connection to the layer 34, whose major role is to provide a low resistance path for the current flowing internally between the transistors. Electrode 39 serves as the source electrode and to this end makes low resistance connection to the source 35. It also makes low resistance connection to the more highly doped (P+) passive central portion 36B of shield region 36. Advantageously, the central portion extends more deeply into the bulk 32 than the annular edge portion. Since the bulk of the shield layer serves the same role as the substrate portion in a conventional MOS transistor, it is maintained at the same potential of the source in accordance with the usual practice of biasing a MOS transistor. It is advantageous to increase the doping in the central region 36B of the shield layer contacted by the electrode 39 to keep the shunting resistance low between regions 36A and 35. Electrode 39 advantageously overlies the gate electrode 37 to serve as a field plate, but is spaced sufficiently therefrom to ensure isolation.

The right transistor spaced apart on the same surface comprises the annular N-type source 40 which is included within the P-type shield region 41, outer lightly-doped surface portion 41A of which serves as the transistor channel in the manner of 36A. This portion is overlaid with the annular oxide-insulated gate electrode 42. The N-type bulk 32 and skin layer 34 also serve as the drain of this transistor and share with the other transistor the drain electrode 38. An electrode 43 makes low resistance connection both to the source 40 and to the passive more heavily doped central region 41B of shield region 41 and overlaps gate electrode 42 in the fashion of electrode 39.

It can be appreciated that in some instances it may be desirable to segment each of source 35 and source 40 into segments, and similarly the gate electrodes 37 and 42, effectively to divide each transistor into two or more transistors, sharing a common drain, which can be connected in parallel. This will be discussed further below.

In operation, assuming that electrode 39 is at the more positive voltage, when the switch is in an ON state, the main current flows between the two electrodes 39 and 43, not only by way of the top surface of the bulk but significantly also from the left transistor vertically downwards through the bulk to the heavily doped skin, laterally through the skin and then upwardly through the bulk to the right transistor.

For this polarity, region 35 serves as the functional source and the bulk as the functional drain of the left transistor while the bulk serves as the functional source and the region 40 as the functional drain of the right transistor. The roles would be reversed for the opposite polarity.

The positions of the various zones in the tub are such as to create a pair of oppositely poled thyristors between the electrodes 39 and 43. In particular, the right-most portion of zone 35 together with the right-most portion of zone 36, the bulk 32, and the left-most portion of zone 41 form an NPNP thyristor of which the N-type bulk 32 serves as the gate and the electrode 38 the gate electrode. In addition, the left-most portion of zone 40, the left-most portion of zone 41, the bulk 32 and the right-most portion of zone 36 form a second oppositely poled NPNP thyristor of which the N-type bulk 32 serves as the gate and the electrode 38 the gate electrode. Alternatively, zone 35, zone 36, bulk 32, zone 41 and zone 40 may be viewed as forming a single five-layer triac between electrodes 39 and 43, of which the bulk 32 and skin layer 34 is the gate. The value of resistors 26 and 27 shown in FIG. 1 will be determined by the properties and dimensions of the bulk 32 and skin layer 34 and are chosen to help realize a desired latching voltage for the thyristors.

Comparing FIGS. 1 and 2, it is seen that the terminals 11 and 12 of FIG. 1 correspond to terminals 44 and 45, connected to electrodes 39 and 43, respectively. Similarly, the connection to node 15 of FIG. 1 corresponds to terminal 46, the connection to electrode 38 of FIG. 2. The gate connections to transistors 13 and 14 of FIG. 1 correspond to the terminals 47 and 48, respectively, the connections to gate electrodes 37 and 42 in FIG. 2.

It will be seen that the solid-state relay essentially includes five terminals. Two of these terminals 44, 45 are the main terminals between which the load currents flow and between which high voltages may be established, which the relay needs to withstand in the OFF state. The other terminals handle only control currents but do encounter the high voltages that may appear between the main terminals. However, each of the gate electrodes is maintained at a voltage which is relatively close to the voltage of its source/shield electrode so that the gate-source/shield voltage difference, which is the critical factor for damaging the gate dielectric, remains relatively small despite a high voltage difference between terminals 11 and 12. Accordingly, since the gate dielectrics of the two transistors need not be designed to withstand high voltage differences between the gate and source/shield, there may be a consequent relaxation of their design requirements. In particular, the dielectrics may be thinner, resulting in lower gate threshold voltages.

Advantageously to minimize latch-up problems, each of the thyristors is designed in known fashion to require a holding current for keeping it in an ON condition, after it is toggled into such condition, which is higher than the current available to it during normal operation. Accordingly, after the abnormal current surges end and normal current flows, the thyristor returns to the OFF state.

Alternatively in some applications, it may be desirable to continue to keep the appropriate thyristor in the ON state so long as the transistors conduct to minimize the series resistance of the switch. In this case, the turn-on current and holding current requirements would be modified appropriately and provision may need to be made to ensure turn-off of the thyristors when the transistors are turned off and the switch is intended to be open.

In the normal linear conduction mode of each thyristor, the shunt resistance between the P-type anode and the N-type gate advantageously is kept at a low value by the heavily doped N-type skin layer 34 and by the conducting channel of the DMOS transistor between the gate and anode terminals. Similarly, the shunt resistance which shorts the P-type shield layer to the N-type source region is made small by including the low resistivity P-type central portion in the shield layer where it is contacted by the source electrode.

Because of these shunting resistors, the starting current of the parasitic thyristor advantageously can be designed to be rather high, thus ensuring a wide range for the linear operation mode before the thyristors start to shunt any current.

These properties which make for a high starting current will also make for a high holding current, as desired, to ensure that the thyristors will be turned off once the current surges have passed and normal current flows. Similarly, these properties make the solid-state relay relatively insensitive to high voltage, high dV/dt transients that are known to switch conventional thyristors from an OFF to ON state.

It is also advantageous in the design that the maximum voltage that the relay can successfully block in the OFF state be primarily determined by the resistivity of the bulk and the spacing between the shield regions 36 and 41. This consideration also requires that the regions 36 and 41 be adequately spaced from the low resistivity region 34.

In the event that the voltage applied to the relay in its OFF state exceeds its maximum blocking voltage, the avalanche multiplication which thereby occurs triggers the thyristor to its low resistance ON state so as to prevent excessive power dissipation and consequent damage to the device. When the over-voltage surge has ceased, the current through the thyristor drops below the holding current and the relay returns to its OFF state.

There are several concepts that the design of a solid-state relay of the kind described can advantageously include. In particular, to maximize the lateral conduction, the transistor geometries should favor large current-carrying channel widths. Similarly, to maximize the vertical conduction, in addition to the heavily doped skin layer, there should be fairly complete coverage of the tub surface in a manner to permit wide linear operation consistent with vertical conduction through the chip.

It is to be noted that in the solid-state relay shown in FIG. 2 only the right-most portion of the left transistor and the left-most portion of the right transistor provide the thyristor trigger action. This suggests that each of the transistors may be divided into two parallel portions without affecting the operation, of which the left portion of the left transistor and the right portion of the right transistor would be designed primarily to provide maximum vertical currents in the transistor mode. This division can be done readily in the embodiment of FIG. 2 if regions 35 and 40 and the gate electrodes are not annular but separate segments, as mentioned above. Embodiments of this kind are described below.

In a switch it will generally be desirable to integrate the control circuitry and the solid-state relay in a common chip.

This can be done advantageously in a switch of the kind shown in FIG. 1 by providing in the chip separate dielectrically isolated tubs for each of the blocking diodes and for the photodiode array, while the resistors 21, 23 can be formed as polycrystalline silicon films deposited over the surface of the chip suitably insulated from the chip and suitably doped, as by ion implantation. The various circuit elements can then be suitably interconnected by conductive interconnect pattern formed over the surface of the chip.

There will be many applications for switches in which protection against overvoltage and current surges needs to be provided for only a single polarity, as for example when terminal 11·will always be the more positive terminal, in which case thyristor 17 is superfluous in the switch shown in FIG. 1.

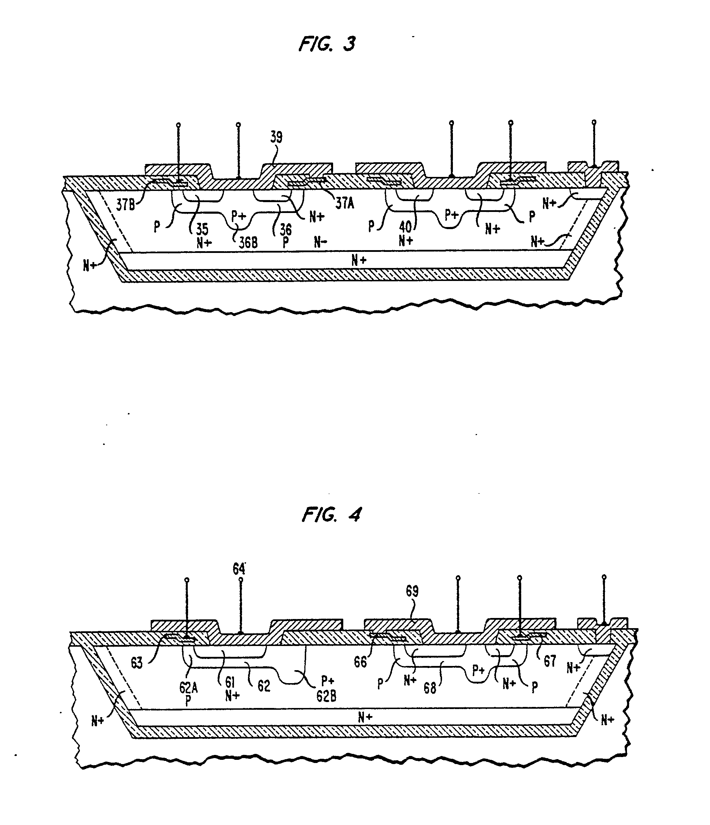

In this instance, the basic relay shown in FIG. 2 may be modified to the form shown in FIG. 3. In this case, the right-most transistor can keep the same form it had in FIG. 2. However, the left transistor is modified for the segmentation of the gate electrode into two sections, one 37A overlying the right-most surface portion of the shielding region 36, which primarily participates in the thyristor action and the other 37B, overlying the left-most surface portion of the shielding region 36, which little participates in the thyristor action. Electrode 37A is connected to electrode 39 whereby it is always maintained at the same potential of the source region 35, thereby ensuring that the underlying region of the shielding region is never inverted in operation and so is inactive to form a channel to participate in the DMOS conduction process. The elimination of this channel facilitates turn-on of the thyristor portion of the device and enables the injection of holes from that portion of shielding region 36 which is closest to cathode region 40, effectively shortening the path the holes need to take and thereby increasing the number of holes reaching the cathode region because of the reduced likelihood of recombination. Also prevented is the formation of a potential barrier in the vicinity of the right-most portion of the shielding region 36 which would otherwise inhibit transport to the cathode of thyristor 16 (region 40) of these holes injected from the anode of the thyristor. Gate electrode 37B is operated in the manner described in FIG. 1 for gate electrodes.

However, it can be appreciated that since this right-hand portion has been made inactive for conduction purposes, it serves little purpose and can be eliminated. In FIG. 4 there is shown such an embodiment.

In this embodiment, the left-most transistor has been truncated and now comprises a localized N-type region 61 surrounded by the shield region 62 which includes a left-most localized surface portion 62A, which is lightly doped and adapted to be inverted to form a channel region, and the more heavily doped remainder 62B. A gate electrode 63 overlies the surface portion 62A and is operated in the manner discussed for gate electrodes in the earlier embodiments. Electrode 64 makes low resistance connection to regions 61 and 62B.

The right-most transistor can take either of two forms. Firstly, it can take the same form it had in FIGS. 2 and 3 in which it includes a gate electrode which is maintained separate from the source/shield electrode whereby it acts to invert selectively the underlying portion of the shield region. One characteristic of this configuration is that when the relay is conducting, at low levels much of the hole current is drawn to the inverted channel portion of the shielding layer. There it tends to recombine with electrons and so makes little contribution to current flow through the relay, until the current becomes sufficient that the resulting voltage drop biases this portion sufficiently that it no longer attracts hole current. Thereafter the hole current flows laterally as desired in the resistive portion of the shielding layer underlying the N-type source region. This raises the potential of the P-type shielding region 68 of the right-most transistor with respect to the N+-type region 40, causing back injection of electrons leading to a regenerative latching-on of the thyristor 16. Furthermore, the trigger current level of the thyristor can be tailored by varying the length of the resistive portion of the P-shielding layer.

Alternatively, if it be desired that the hole current flow initially primarily into the resistive portion of the shielding layer underlying the N-type source region, then as shown in FIG. 4, separate gate electrodes 66, 67 should be provided to overlie the left and right surface portions, respectively, of the shielding layer 68. Gate electrode 66 is then connected directly to source/shield electrode 69 whereby the underlying portion of shielding layer 68 is prevented from being inverted and rendered inactive. Gate electrode 67 is operated in the manner of the gate electrodes in the earlier embodiments.

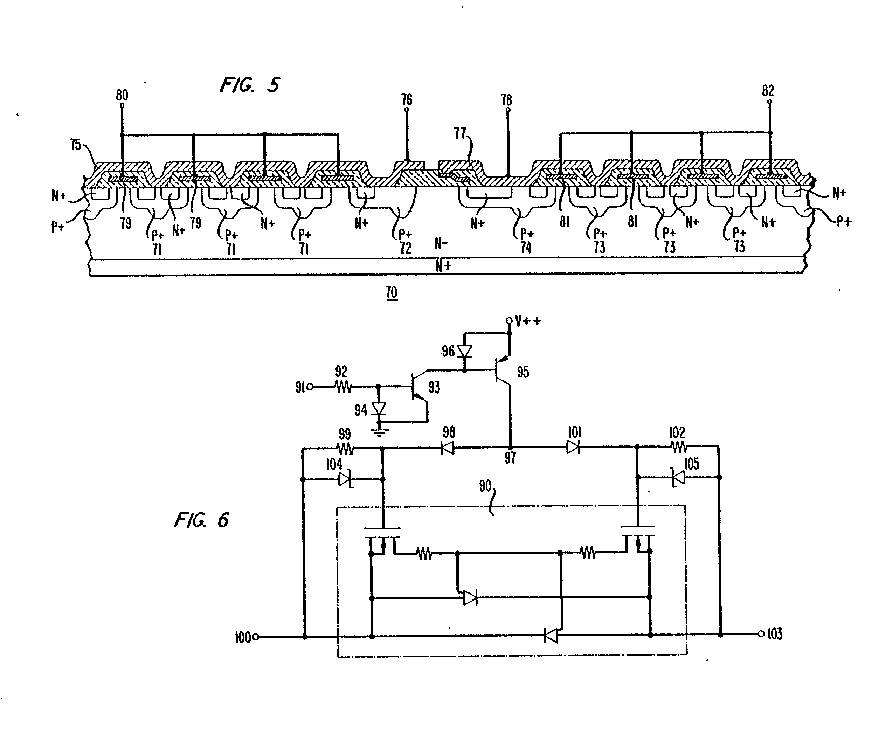

For applications where large currents are to be switched, it is advantageous to include in a single tub a number of transistors in parallel to handle such currents efficiently. Ordinarily these are most effectively combined if arranged in a substantially rectangular two-dimensional array rather than in a single line. In FIG. 5, there is shown one line of such a rectangular array. This line is designed to include only a single thyristor to provide protection only in a single direction. If only single direction protection is desired, all the lines would have this same orientation. However, if bilateral protection is desired, advantageously successive lines in the direction normal to the plane of the drawing would have their left-right orientation reversed. This will become more apparent as the description of this embodiment progresses.

In the relay portion 70 shown in FIG. 5, the various elements may be considered as forming a left and a right set. The left set comprises in parallel a plurality of vertical DMOS transistors 71 of the kind included in the embodiment of FIG. 2, with adjacent ones having common gate electrodes 79, and including at the right edge a transistor 72 of the kind shown at the left in the embodiment of FIG. 4. The right set comprises in parallel a plurality of vertical DMOS transistors 73 of the kind in the left set with adjacent ones having common gate electrodes 81, and further including at its left edge a transistor 74 of the kind shown as the right transistor in the embodiment of FIG. 4. Transistors 72 and 74 cooperate to form a thyristor as described in connection with FIG. 4. The remaining transistors primarily serve to provide a controllably switched path between the left and right terminals 76 and 78.

As seen in the drawing, the source/shield regions of each of the transistors of the left set share a common electrode 75 which is connected to terminal 76, corresponding to terminal 11 of the switch shown in FIG. 1. The source/shield regions of each of the transistors of the right set share a common electrode 77 connected to terminal 78, corresponding to terminal 12 of the switch shown in FIG. 1.

The gate electrodes 79 of each transistor of the left set are all interconnected to common terminal 80 and the gate electrodes 81 of each transistor of the right set except the left-most are all interconnected to a common terminal 82. The gate electrode of the left-most transistor is connected instead to the electrode 77 as discussed in connection with FIG. 4. Finally, advantageously a connection, not shown, is made to a heavily doped N-type region at the edge of the tub to form the common connection to the bulk of the body corresponding to the node 15 in the switch of FIG. 1.

As discussed in connection with FIG. 4, the turn-on current of the thyristor can be controlled by the length of the resistive portion of the shielding layer underlying its cathode, the N-type source of transistor 74. Thus, its length is shown longer than the sources of the other transistors.

As alluded to above, if bidirectional protection is desired, there is merely alternated the right and left sets in adjacent lines of the two dimensional array so that successive lines include oppositely poled thyristors.

This embodiment has a number of advantages. The thyristor formed by transistors 72 and 74 saves space since it effectively moves the cathode and anode of the thyristor closer by the elimination of extraneous regions as compared to the thyristor formed in the embodiment of FIG. 2.

The elimination of the channel regions from the thyristor path reduces its impedance and removes a potential barrier to permit more efficient flow from anode to cathode and to remove a sink for hole current as previously discussed.

Additionally, the partial unmerging permits the majority of the transistors to be designed primarily to conduct current efficiently and permits close spacing of such transistors since only the spacing between the innermost transistor of each set needs be sufficient to withstand the high voltages the switch is intended to withstand. this should make possible the realization of higher currents · per unit area of tub surface and the achievement of low series resistance for the switch because of the efficient use of the N+-type skin layer for lateral flow between the two sets.

It should be evident that in addition to paralleling a number of elements in a common tub while sharing common auxiliary circuitry for increased current handling ability it should also be feasible to parallel a number of solid-state relays of the kind described in separate tubs.

It will, of course, be apparent that there can be used auxiliary circuits in which the control portion employs external electrical signals directly rather than photovoltaic voltages.

FIG. 6 shows a switch which can employ any of the forms of solid-state relays previously described with reference to Figs. 3, 4 and 5 and which is adapted to be switched by TTL electrical signals rather than by optical pulses. The switching signal is supplied to input control terminal 91 and after passing through resistor 92 is applied to the base of the level shifting NPN bipolar transistor 93 whose emitter is grounded and whose base is also connected to ground by way of the diode 94.

The collector of transistor 93 is connected to the base of PNP bipolar transistor 95 whose emitter is tied to the source of most positive potential in the circuit V++ and by way of diode 96 to its base. The collector of transistor 95 is connected to node 97. The transistor 95 acts as a current mirror and provides a signal current which is the image of the signal current of transistor 93 apppropriately shifted in voltage level. Node 97 is connected by way of blocking diode 98 and resistor 99 to one main terminal 100 and by way of blocking diode 101 and resistor 102 to the other main terminal 103. The node between diode 98 and resistor 99 is connected to one gate electrode of the solid-state relay 90 and the node between diode 101 and resistor 102 is connected to the other gate electrode. Zener diodes 104 and 105 are connected across resistors 99 and 102, respectively, to clamp the source-gate bias of each of the DMOS transistors so as to protect the gates from overvoltage damage.

Positive signals applied to terminal 91 are effective in switching the resistance between terminals 100 and 103 from a high to a low state.

From the foregoing it should be apparent that a variety of control circuits can be used successfully with the solid-state relay to achieve a desired form of switch.

It should also be apparent that the polarities of the various zones of the relay might be reversed to incorporate p-channel DMOS transistors and to adopt the relay to switching by negative pulses applied to the gates.

Moreover, it should be appreciated that although DMOS transistors historically involved a simultaneous double-diffusion process for making the source and drain regions, other fabrication techniques including technologies, such as that described as VMOS, may be employed to form the characteristic pair of closely spaced P-N junctions at a surface portion of a silicon chip.

## Claims

1. A switch (fig. 1:10) including a semiconductor body having a bulk portion of relatively high resistivity of one conductivity type, and within the bulk portion first (fig. 4:61) and second spaced apart surface source regions of the one conductivity type, and first (62) and second (68) spaced shield regions of the opposite conductivity type enclosing the first and second source regions, respectively, a first electrode making a direct electrical connection to both the first source and first shield regions, a second electrode (69) making a direct electrical connection to both the second source and second shield regions, and characterised by a third electrode (63) overlying and insulated from a surface portion (62A) of the first shield region relatively remote from the second shield region (68) for serving as a gate electrode for selectively inverting that portion of the shield region and forming a channel therein, a fourth electrode (67) overlying and insulated from a surface portion of the second shield region relatively remote from the first shield region for serving as a gate electrode for selectively inverting that portion of the second shield region and forming a channel therein, and a fifth electrode (66) overlying and insulated from a surface portion of the second shield region relatively adjacent the first shield region and making a direct electrical connection to the second electrode (69), the first source region (61), the portion (62A) of the first shield region relatively remote from the second shield region, the bulk portion and the third electrode (63) cooperating to form a first MOS transistor, the second source region, the portion of the second shield region relatively remote from the first shield region, the bulk portion and the fourth electrode (67) cooperating to form a second MOS transistor, and the first shield region (62), the bulk portion, the second shield region (68), and the second source region cooperating to form a thyristor, and a pair of oppositely poled diodes (fig. 1:20, 22) having a common terminal (19) connected to a source of control signals (Fig. 1:18) and two other terminals connected to the third (63) and fourth (67) electrodes, respectively.

2. A switch (fig. 1:10) including a semiconductor body having a bulk portion of relatively high resistivity of one conductivity type, and within the bulk portion first (35) and second (40) spaced apart surface source region of the one conductivity type, and first (36) and second spaced shield regions of the opposite conductivity type enclosing the first and second source regions, respectively, a first electrode (39) making a direct electrical connection to the first source and first shield regions, and a second electrode making a direct electrical connection to the second source and second shield regions, characterised by a third electrode (37B) overlying only a limited surface portion of the first shield region relatively remote from the second shield region and insulated therefrom for serving as a gate electrode for selectively inverting that portion of the shielding region and forming a channel therein, a fourth electrode overlying essentially all of the surface portion of the second shielding region for selectively inverting that surface portion of the shielding region and forming a channel therein, the first source region (35) the portion of the first shield region underlying the third electrode, the bulk portion and the third electrode (37B) cooperating to form a first MOS transistor, the second source region (40), the second shield region, the bulk portion and the fourth electrode cooperating to form a second MOS transistor, and the portion of the first shield region relatively close to the second shield region, the bulk portion, the second shield region, and the second source region (40) cooperating to form a thyristor, and a pair of oppositely poled diodes (fig. 1:20, 22) having a common terminal (19) connected to a source of control signals (18) and two other terminals connected to the third and fourth electrodes, respectively.

3. A switch as claimed in claim 1 or 2 including a further oppositely poled thyristor connected between the sources of the two transistors.

4. A switch as claimed in claim 3 wherein the further thyristor is formed by the portion of the second shield region relatively close to the first source region, the bulk portion, the first shield region and the first source region, the bulk portion serving as the gate of each of the thyristors.

5. A switch (fig. 1:10) including a semiconductor body having a bulk portion of relatively high resistivity of one conductivity type, and characterised in that within the bulk there are first (71, 72) and second (73, 74) sets of MOS transistors and at least one set of thyristors, each transistor including a surface source region of the one conductivity type, a drain region of the one conductivity type and intermediate the source and drain regions a shield region of the opposite conductivity type surrounding the source region and including a surface portion adapted to be inverted for forming a channel between the source and drain regions, the drain regions of all the transistors being merged in the bulk portion, the switch further including a first set of source/shield electrode means (75) for making direct electrical connection both to each source and shield regions of the first set of MOS transistors, a second set of source/shield electrode means (77) for making direct electrical connection both to each source and shield regions of the second set of MOS transistors, a first set of gate electrode means (79) overlying and insulated from the surface portions to be inverted for forming channels of the first set of MOS transistors, a second separate set of gate electrode means (81) overlying and insulated from the surface portions to be inverted for forming channels of the second set of MOS transistors, each thyristor comprising a first cathode surface region of the one conductivity type, a second enclosing region of the opposite conductivity type surrounding the cathode region, a third anode-gate region of the one conductivity type enclosing the second region, and a fourth anode region of the opposite conductivity type enclosed within the third region, the second region including a first surface portion relatively remote from the anode region adapted to be inverted for forming a channel between the first and third regions and a second surface portion relatively close to the anode region adapted to remain uninverted, the anode-gate regions of all the thyristors being merged with one another and with the drain regions of all the transistors in the bulk portion of the body, cathode electrode means making direct electrical connection to the cathode and second regions of each thyristor and the first set of source/shield electrode means, gate electrode means overlying and dielectrically spaced from each first surface portion of the second region for inverting that surface portion and forming the channel between the cathode and anode-gate region, the gate electrode means being directly connected to the first set of gate electrode means, anode electrode means making direct connection to the fourth anode regions of all the thyristors and the second set of source/shield electrode means, and a pair of oppositely poled diodes (fig. 1:20, 22) having a common terminal (19) connected to a source of control signals (18) and two other terminals connected to the first and second sets of gate electrode means, respectively.

6. A switch as claimed in claim 5 wherein the semiconductor body further includes a second set of thyristors whose cathode electrode means are connected to the second set of source/shield electrode means, whose gate electrode means are connected to the second set of gate electrode means, and whose anode electrode means are connected to the first set of source/shield electrode means.

7. A switch as claimed in any preceding claim wherein the bulk portion is surrounded beneath its surface by a layer of the same conductivity type as the bulk portion, but of relatively lower resistivity.

8. A switch as claimed in any preceding claim wherein respective resistances are connected between the first and third electrodes and between the second and fourth electrodes, or, as the case may be, between the first set of source/shield electrode means and the first set of gate electrode means and between the second set of source/ shield electrode means and the second set of gate electrode means.

9. A switch as claimed in any preceding claim wherein the source of control signals is photovoltaic means adapted to be illuminated by light pulses.

10. A switch as claimed in any one of claims 1 to 8 wherein the source of control signals includes a source of electrical pulses adapted for charging each of the gate electrodes of the transistors to form conductive channels therein.

11. A switch as claimed in any preceding claim including a terminal connecting the source of control signals of the common drain.

## Revendications

1. Un élément de commutation (figure 1:10) comprenant un bloc de semiconducteur ayant une partie de volume principal de résistivité relativement élevée et d'un premier type de conductivité, et à l'intérieur de la partie de volume principal des première (figure 4:61) et seconde régions de source de surface mutuellement espacées et du premier type de conductivité, et des première (62) et seconde (68) régions d'écran espacées, du type de conductivité opposé, entourant respectivement les première et seconde régions de source, une première électrode établissant une connexion électrique directe à la fois avec la première région de source et la première région d'écran, une seconde électrode (69) établissant une connexion électrique directe à la fois avec la seconde région de source et la seconde région d'écran, et caractérisé par une troisième électrode (63) recouvrant, en en étant isolée, une partie de surface (62A) de la première région d'écran relativement éloignée de la seconde région d'écran (68), pour faire fonction d'électrode de grille destinée à inverser sélectivement cette partie de la région d'écran et à former un canal à l'intérieur, une quatrième électrode (67) recouvrant, en en étant isolée, une partie de surface de la seconde région d'écran relativement éloignée de la première région d'écran, pour constituer une électrode de grille destinée à inverser sélectivement cette partie de la seconde région d'écran et à former un canal à l'intérieur, et une cinquième électrode (66) recouvrant, en en étant isolée, une partie de surface de la seconde région d'écran relativement adjacente à la première région d'écran, et établissant une connexion électrique directe avec la seconde électrode (69), la première région de source (61), la partie (62A) de la première région d'écran relativement éloignée de la seconde région d'écran, la partie de volume principal et la troisième électrode (63) coopérant de façon à former un premier transistor MOS, la seconde région de source, la partie de la seconde région d'écran relativement éloignée de la première région d'écran, la partie de volume principal et la quatrième électrode (67) coopérant pour former un second transistor MOS, et la première région d'écran (62), la partie de volume principal, la seconde région d'écran (68) et la seconde région de source coopérant pour former un thyristor; et par une paire de diodes (figure 1:20, 22) ayant des polarités opposées et une borne commune (19) connectée à une source de signaux de commande (figure 1:18), et deux autres bornes respectivement connectées aux troisième (63) et quatrième (67) électrodes.

2. Un élément de commutation (figure 1:10) comprenant un bloc de semiconducteur ayant une partie de volume principal de résistivité relativement élevée et d'un premier type de conductivité, et à l'intérieur de la partie de volume principal des première (35) et seconde (40) régions de source de surface mutuellement espacées et du premier type de conductivité, et des première (36) et seconde régions d'écran espacées du type de conductivité opposé, entourant respectivement les première et seconde régions de source, une première électrode (39) établissant une connexion électrique directe avec la première région de source et la première région d'écran, et une seconde électrode établissant une connexion électrique directe avec la seconde région de source et la seconde région d'écran, caractérisé par une troisième électrode (37B) recouvrant seulement une partie de surface limitée de la première région d'écran relativement éloignée de la seconde région d'écran, et étant isolée par rapport à celle-ci, pour constituer une électrode de grille destinée à inverser sélectivement cette partie de la région d'écran et à former un canal à l'intérieur, une quatrième électrode recouvrant pratiquement la totalité de la partie de surface de la seconde région d'écran, pour inverser sélectivement cette partie de surface de la région d'écran et pour former un canal à l'intérieur, la première région de source (35), la partie de la première région d'écran qui se trouve sous la troisième électrode, la partie de volume principal et la troisième électrode (37B) coopérant pour former un premier transistor MOS, la seconde région de source (40), la seconde région d'écran, la partie de volume principal et la quatrième électrode coopérant pour former un second transistor MOS; et la partie de la première région d'écran relativement proche de la seconde région d'écran, la partie de volume principal, la seconde région d'écran et la seconde région de source (40) coopérant pour former un thyristor; et par une paire de diodes (figure 1:20, 22) ayant des polarités opposées et une borne commune (19) connectée à une source de signaux de commande (18) et deux autres bornes respectivement connectées aux troisième et quatrième électrodes.

3. Un élément de commutation selon la revendication 1 ou 2, comprenant un thyristor supplémentaire ayant une polarité opposée, qui est connecté les sources des deux transistors.

4. Un élément de commutation selon la revendication 3 dans lequel le thyristor supplémentaire est formé par la partie de la seconde région d'écran relativement proche de la première région de source, la partie de volume principal, la première région d'écran et la première région de source, la partie de volume principal constituant la gâchette de chacun des thyristors.

5. Un élément de commutation (figure 1:10) comprenant un bloc de semiconducteur ayant une partie de volume principal de résistivité relativement élevée d'un premier type de conductivité, et caractérisé en ce qu'à l'intérieur du volume principal se trouvent des premier (71, 72) et second (73, 74) jeux de transistors MOS, et au moins un jeu de thyristors, chaque transistor comprenant une région de source de surface du premier type de conductivité, une région de drain du premier type de conductivité et, entre les régions de source et de drain, une région d'écran du type de conductivité opposé entourant le région de source et comprenant une partie de surface prévue pour subir une inversion de façon à former un canal entre les régions de source et de drain, les régions de drain de tous les transistors étant réunies dans la partie de volume principal, l'élément de commutation comprenant en outre un premier jeu de structures d'électrodes de source/écran (75) destinées à établir une connexion électrique directe à la fois avec chaque région de source et chaque région d'écran du premier jeu de transistors MOS, un second jeu de structures d'électrodes de source/écran (77) destinées à établir une connexion électrique directe à la fois avec chaque région de source et chaque région d'écran du second jeu de transistors MOS, un premier jeu de structures d'électrode de grille (79) recouvrant, en en étant isolées, les parties de surface à inverser pour former des canaux du premier jeu de transistors MOS, un second jeu séparé de structures d'électrodes de grille (81) recouvrant, en en étant isolées, les parties de surface à inverser pour former des canaux du second jeu de transistors MOS, chaque thyristor comprenant une première région de surface de cathode du premier type de conductivité, une seconde région enveloppante du type de conductivité opposé entourant la région de cathode, une troisième région d'anode-gâchette du premier type de conductivité entourant la seconde région, et une quatrième région d'anode du type de conductivité opposé, enfermée à l'intérieur de la troisième région, la seconde région comprenant une première partie de surface relativement éloignée de la région d'anode et prévue pour être inversée de façon à former un canal entre les première et troisième régions, et une seconde partie de surface relativement proche de la région d'anode et conçue de façon à rester non inversée, les régions d'anode-gâchette de tous les thyristors étant réunies ensemble et avec les régions de drain de tous les transistors, dans la partie de volume principal du bloc, une structure d'électrode de cathode établissant une connexion électrique directe avec la cathode et les secondes régions de chaque thyristor, et le premier jeu de structures d'électrodes de source/écran, une structure d'électrode de grille recouvrant, en en étant espacée par un diélectrique, chaque première partie de surface de la seconde région, pour inverser cette partie de surface et former le canal entre la région de cathode et la région d'anode-gâchette, la structure d'électrode de grille étant directement connectée au premier jeu de structures d'électrodes de grille, une structure d'électrode d'anode établissant une connexion directe avec les quatrièmes régions d'anode de tous les thyristors et avec le second jeu de structures d'électrodes de source/écran, et une paire de diodes (figure 1:20, 22) ayant des polarités opposées et une borne commune (19) connectée à une source de signaux de commande (18) et deux autres bornes respectivement connectées aux premier et second jeux de structures d'électrode de grille.

6. Un élément de commutation selon la revendication 5, dans lequel le bloc de semiconducteur comprend en outre un second jeu de thyristors dont la structure d'électrode de cathode est connectée au second jeu de structures d'électrodes de source/écran, dont la structure d'électrode de grille est connectée au second jeu de structures d'électrodes de grille, et dont la structure d'électrode d'anode est connectée au premier jeu de structures d'électrodes de source/écran.

7. Un élément de commutation selon l'une quelconque des revendications précédentes, dans lequel la partie de volume principal est entourée, au-dessous de sa surface, par une couche du même type de conductivité que la partie de volume principal, mais de résistivité relativement inférieure.

8. Un élément de commutation selon l'une quelconque des revendications précédentes, dans lequel des résistances respectives sont connectées entre les première et troisième électrodes et entre les seconde et quatrième électrodes, ou, selon le cas, entre le premier jeu de structures d'électrodes de source/écran et le premier jeu de structures d'électrode de grille, et entre le second jeu de structures d'électrodes de source/écran et le second jeu de structures d'électrode de grille.

9. Un élément de commutation selon l'une quelconque des revendications précédentes, dans lequel la source de signaux de commande est constituée par des moyens photovoltaïques prévus pour être illuminés par des impulsions lumineuses.

10. Un élément de commutation selon l'une quelconque des revendications 1 à 8, dans lequel la source de signaux de commande comprend une source d'impulsions électriques prévues pour charger chacune des électrodes de grille des transistors afin de former des canaux conducteurs dans ces derniers.

11. Un élément de commutation selon l'une quelconque des revendications précédentes comprenant une borne qui connecte la source de signaux de commande au drain commun.

**Patentansprüche**

1. Schalter (Fig. 1; 10) mit
— einem Halbleiterkörper mit einem Volumhauptteil relativ hohen spezifischen Widerstandes und vom einen Leitungstyp und
— innerhalb des Hauptvolumteils einer ersten (Fig. 4; 61) und einer zweiten Oberflächen-Source-Zone des einen Leitungstyps, die im Abstand voneinander liegen, und einer ersten (62) und zweiten (68) Abschirmzone des entgegengesetzten Leitungstyps, die im Abstand voneinander liegen und die erste bzw. zweite Source-Zone umgeben,
— einer ersten Elektrode, die eine direkte elektrische Verbindung sowohl zur ersten Source-Zone als auch zur ersten Abschirmzone herstellt,
— einer zweiten Elektrode (69), die eine direkte elektrische Verbindung sowohl ·zur zweiten Source-Zone als auch zur zweiten Abschirmzone herstellt,
und gekennzeichnet durch
— eine dritte Elektrode (63), die über einem von der zweiten Abschirmzone relativ entfernten Oberflächenteil (62A) der ersten Abschirmzone liegt, hiergegen isoliert ist und als Gatelektrode zum selektiven Invertieren jenes Abschirmzonenteils und zum Ausbilden eines Kanals hierin dient,
— eine vierte Elektrode (67), die über einem von der ersten Abschirmzone relativ entfernten Oberflächenteil der zweiten Abschirmzone liegt, hiergegen isoliert ist und als Gateelektrode zur selektiven Invertierung jenes Teil der zweiten Abschirmzone und zum Ausbilden enes Kanals hierin dient, und
— eine fünfte Elektrode (66), die über einem zur ersten Abschirmzone relativ benachbarten Oberflächenteil der zweiten Abschirmzone liegt, hiergegen isoliert ist und eine direkte elektrische Verbindung zur zweiten Elektrode (69) herstellt, wobei
—— die erste Source-Zone (61), der von der zweiten Abschirmzone relativ entfernte Teil (21A) der ersten Abschirmzone, der Hauptvolumteil und die dritte Elektrode (63) zur Bildung eines ersten MOS-Transistors zusammenwirken,
—— die zweite Source-Zone, der von der ersten Abschirmzone relativ entfernte Teil der zweiten Abschirmzone, der Hauptvolumteil und die vierte Elektrode (67) zur Bildung eines zweiten MOS-Transistors zusammenwirken und
—— die erste Abschirmzone (62), der Hauptvolumteil, die zweite Abschirmzone (68) und die zweite Source-Zone zur Bildung eines Thyristors zusammenwirken und
— ein Paar entgegengesetzt gepolte Dioden (Fig. 1; 20, 22), die mit einem mit einer Steuersignalquelle (Fig. 1; 18) verbundenen gemeinsamen Anschluß (19) und mit zwei weiteren, mit der dritten (63) bzw. vierten (67) Elektrode verbundenen Anschlüssen versehen sind.

2. Schalter (Fig. 1; 10) mit
— einem Halbleiterkörper mit einem Hauptvolumteil vergleichsweise hohen spezifischen Widerstandes von einem Leitungstyp und, innerhalb des Hauptvolumteils, mit einer ersten (35) und zweiten (40) Oberflächen-Source-Zone des einen Leitungstyps, die voneinander im Abstand liegen, und einer ersten (36) und zweiten Abschirmzone des entgegengesetzten Leitungstyps, die voneinander im Abstand liegen und die erste bzw. zweite Source-Zone umgeben,
— einer ersten Elektrode (39), die eine direkte elektrische Verbindung zur ersten Source-Zone und zur ersten Abschirmzone herstellt und
— einer zweiten Elektrode, die eine direkte elektrische Verbindung zur zweiten Source-Zone und zweiten Abschirmzone herstellt,
gekennzeichnet durch
— eine dritte Elektrode (37B), die nur über einem begrenzten, von der zweiten Abschirmzone relativ entfernten Oberflächenteil der ersten Abschirmzone liegt, hiergegen isoliert ist und als Gateelektrode zum selektiven Invertieren jenes Teils der Abschirmzone und zum Ausbilden eines Kanals hierin dient,
— eine vierte Elektrode, die über im wesentlichen dem ganzen Oberflächenteil der zweiten Abschirmzone liegt und zum selektiven Invertieren jenes Oberflächenteils der Abschirmzone und zum Ausbilden eines Kanals hierin dient, wobei
—— die erste Source-Zone (35), der unter der dritten Elektrode liegende Teil der ersten Abschirmzone, der Hauptvolumteil und die dritte Elektrode (37B) zur Bildung eines ersten MOS-Transistors zusammenwirken,
—— die zweite Source-Zone (40), die zweite Abschirmzone, der Hauptvolumteil und die vierte Elektrode zur Bildung eines zweiten MOS-Transistors zusammenwirken und
—— der vergleichsweise nahe zur zweiten Abschirmzone gelegene Teil der ersten Abschirmzone, der Hauptvolumteil, die zweite Abschirmzone und die zweite Source-Zone (40) zur Bildung eines Thyristors zusammenwirken, und
— ein Paar entgegengesetzt gepolter Dioden (Fig. 1; 20, 22) mit einem gemeinsamen Anschluß (19), der mit einer Steuersignalquelle (18) verbunden ist, und zwei weiteren Anschlüssen, die mit der dritten bzw. vierten Elektrode verbunden sind, versehen sind.

3. Schalter wie in Anspruch 1 oder 2 beansprucht, mit einem weiteren, entgegengesetzt gepolten Thyristor der die Sourcen der beiden Transistoren verbindet.

4. Schalter wie in Anspruch 3 beansprucht, wobei der weitere Thyristor gebildet ist durch den zur ersten Source-Zone vergleichsweise nahen Teil der zweiten Abschirmzone, den Hauptvolumteil, die erste Abschirmzone und die erste Source-Zone, wobei der Hauptvolumteil als das Gate eines jeden der Thyristoren dient.

5. Schalter (Fig. 1; 10) mit
— einem Halbleiterkörper mit einem Hauptvolumteil relativ hohen spezifischen Widerstandes von einem Leitungstyp, dadurch gekennzeichnet, daß
— innerhalb des Hauptvolumteils eine erste (71, 72) und eine zweite (73, 74) MOS-Transistorgruppe und wenigstens eine Thyristorgruppe vorgesehen sind,
— jeder Transistor aufgebaut ist aus einer Oberflächen-Source-Zone des einen Leitungstyps, einer Drain-Zone des einen Leitungstyps und, zwischen der Source- und Drain-Zone, einer Abschirmzone des entgegengesetzten Leitungstyps, die die Source-Zone umgibt und einen Oberflächenteil aufweist, der zur Bildung eines Kanals zwischen Source- und Drain-Zone invertierbar ist,
— die Drain-Zonen aller Transistoren im Hauptvolumteil vereinigt sind,
— der Schalter des weiteren versehen ist mit einer ersten Gruppe von Source/Abschirm-Elektrodenmitteln (75) zum Herstellen einer direkten elektrischen Verbindung sowohl zu jeder Source- als auch Abschirmzone der ersten MOS-Transistorgruppe, einer zweiten Gruppe von Source/Abschirmungs-Elektrodenmitteln (77) zum Herstellen einer direkten elektrischen Verbindung sowohl zu jeder Source- als auch Abschirmzone der zweiten MOS-Transistorgruppe, einer ersten Gruppe von Gate-Elektrodenmitteln (79), die über jenen Oberflächenteilen gelegen und hiergegen isoliert sind, welche zur Bildung von Kanälen der ersten MOS-Transistorgruppe zu invertieren sind, einer zweiten, getrennten Gruppe von Gateelektrodenmitteln (81), die über jenen Oberflächenteilen gelegen und hiergegen isoliert sind, welche zur Bildung von Kanälen der zweiten MOS-Transistorgruppe zu invertieren sind,
— jeder Thyristor aufgebaut ist aus einer Kathodenoberflächenzone des einen Leitungstyps als erster Zone, einer Einschließungszone des entgegengesetzten Leitungstyps als zweiter Zone, die die Kathodenzone umgibt, einer Anoden-Gate-Zone des einen Leitungstyps als dritter Zone, die die zweite Zone umgibt, und einer Anodenzone des entgegengesetzten Leitungstyps als vierter Zone, die innerhalb der dritten Zone eingeschlossen ist,
— die zweite Zone versehen ist mit einem ersten Oberflächenteil, der von der Anodenzone relativ entfernt und zur Ausbildung eines Kanals zwischen der ersten und dritten Zone invertierbar ist, und einem zweiten Oberflächenteil, der relativ nahe bei der Anodenzone gelegen ist und dafür ausgelegt ist, uninvertiert zu bleiben,

— die Anoden-Gate-Zonen aller Thyristoren miteinander und mit den Drainzonen aller Transistoren im Hauptvolumteil des Körpers vereinigt sind,
— Kathodenelektrodenmittel direkte elektrische Verbindung zu der Kathodenzone und zur zweiten Zone jedes Thyristors und zur ersten Gruppe der Source Abschirmungs-Elektrodenmittel herstellen,
— Gate-Elektrodenmittel, die über jedem ersten Oberflächenteil der zweiten Zone liegen und hiergegen dielektrisch beabstandet sind, um jenen Oberflächenteil zu invertieren und den Kanal zwischen der Kathodenzone und der Anoden-Gatezone zu bilden,
— die Gateelektrodenmittel direkt mit der ersten Gruppe der Gateelektrodenmittel verbunden sind,
— die Anodenelektrodenmittel eine direkte Verbindung zu den vierten Anodenzonen aller Thyristoren und zur zweiten Gruppe der Source-Abschirmungs-Elektrodenmittel herstellen und
— ein Paar entgegengesetzt gepolter Dioden (Fig. 1; 20, 22) vorgesehen sind, die mit einem gemeinsamen Anschluß (19), der mit einer Steuersignalquelle (18) verbunden ist, und mit zwei weiteren Anschlüssen versehen ist, die mit der ersten bzw. zweiten Gruppe der gateelektrodenmitteln verbunden sind.

6. Schalter wie in Anspruch 5 beansprucht, wobei der Halbleiterkörper des weiteren eine zweite Thyristorgruppe umfaßt, deren Kathodenelektrodenmitteln mit der zweiten Gruppe von Source/Abschirmungselektrodenmitteln verbunden sind, deren Gateelektrodenmittel mit der zweiten Gruppe der Gateelektrodenmittel verbunden sind und deren Anodenelektrodenmittel mit der ersten Gruppe von Source/Abschirmungselektrodenmitteln verbunden sind.

7. Schalter wie in einem der vorstehenden Ansprüche beansprucht, wobei der Hauptvolumteil unterhalb seiner Oberfläche von einer Schicht desselben Leitungstyps wie der Hauptvolumteil, jedoch von vergleichsweise kleinerem spezifischem Widerstand umgeben ist.

8. Schalter wie in einem der vorstehenden Ansprüche beansprucht, wobei entsprechende Widerstände zwischen den ersten und dritten Elektroden und zwischen den zweiten und vierten Elektroden liegen oder, im gegebenen Fall, zwischen der ersten Gruppe von Source/Abschirmungselektrodenmitteln und der ersten Gruppe von gateelektrodenmitteln und zwischen der zweiten Gruppe von Source/Abschirmungselektrodenmitteln und der zweiten Gruppe von Gateelektrodenmitteln liegen.

9. Schalter wie in einem der vorstehenden Ansprüche beansprucht, wobei die Steuersignalquelle eine photovoltaische Einrichtung ist, die dafür ausgelegt ist, durch Lichtimpulse beleuchtet zu werden.

10. Schalter wie in einem der Ansprüche 1 bis 8 beansprucht, wobei die Steuersignalquelle eine Quelle für elektrische Impulse einschließt, die jede der Gateelektroden der Transistoren zur Bildung leitender Kanäle hierin aufzuladen vermögen.

11. Schalter wie in einem der vorstehenden Ansprüche beansprucht, mit einem Anschluß, der die Steuersignalquelle mit dem gemeinsamen Drain verbindet.

*FIG. 1*

*FIG. 2*

## FIG. 3

## FIG. 4

FIG. 5

FIG. 6